# EUROPEAN PATENT SPECIFICATION

(11) **EP 3 352 238 B1**
(45) Date of publication and mention of the grant of the patent: **12.05.2021**
(21) Application number: 16763187.8
(22) Date of filing: 18.02.2016
(51) Int. Cl.: H01L 51/56, H01L 51/52

(54) **METHOD FOR PREPARING UNEVEN PARTICLE LAYER, ORGANIC ELECTROLUMINESCENT DEVICE, AND DISPLAY DEVICE**
VERFAHREN ZUR HERSTELLUNG EINER UNEBENEN PARTIKELSCHICHT, ORGANISCHE ELEKTROLUMINESZENTE VORRICHTUNG UND ANZEIGEVORRICHTUNG
PROCÉDÉ DE PRÉPARATION DE COUCHE DE PARTICULES IRRÉGULIÈRE, DISPOSITIF ÉLECTROLUMINESCENT ORGANIQUE, ET DISPOSITIF D'AFFICHAGE

(30) Priority: 17.09.2015 CN 201510596057
(43) Date of publication of application: 25.07.2018
(73) Proprietor: BOE Technology Group Co., Ltd., Beijing 100015 (CN); Hefei BOE Optoelectronics Technology Co., Ltd., Hefei, Anhui 230012 (CN)
(72) Inventor: GUO, Yuanhui, Beijing 100176 (CN); ZANG, Yuansheng, Beijing 100176 (CN); LIU, Zhi, Beijing 100176 (CN); LI, Xiaohe, Beijing 100176 (CN); WANG, Hui, Beijing 100176 (CN)
(74) Representative: Cohausz & Florack
(86) International application number: PCT/CN2016/073987
(87) International publication number: WO 2017/045355

(56) References cited:
- WO-A1-2004/029176
- WO-A1-2014/178798
- WO-A1-2016/096937
- CN-A- 102 701 143
- CN-A- 102 701 143
- CN-A- 103 503 571
- CN-A- 103 688 385
- CN-A- 103 943 738
- CN-A- 105 118 934
- US-A1- 2007 042 174
- US-A1- 2015 179 977
- US-B1- 8 940 562

## Description

### FIELD OF THE INVENTION

The present invention relates to the field of display technology, and particularly relates to a method for preparing an uneven particle layer, an organic light emitting diode device and a display device comprising the uneven particle layer.

### BACKGROUND OF THE INVENTION

An OLED (Organic Light Emitting Diode) device simultaneously has the excellent characteristics of being self-luminous, free of backlight, high in contrast, small in thickness, wide in viewing angle, high in response speed, available for flexible panels, wide in using temperature range, simple in constructing and manufacturing procedures and the like, thereby being deemed as an emerging technology of the next-generation flat display devices.

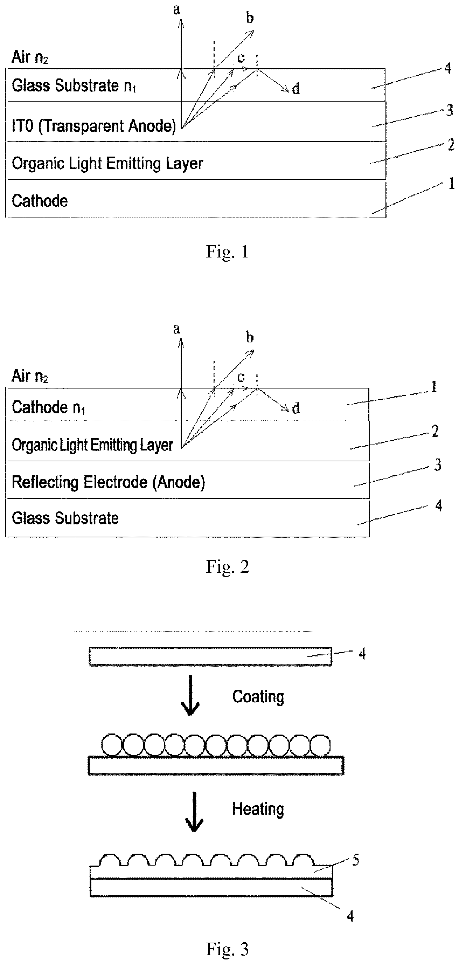

The existing OLED has a structure as shown in schematic diagrams Fig.1 and Fig.2, and it includes a cathode, an organic light emitting layer, an anode and a glass substrate.

The inventor finds that the prior art at least has the following problems: when a photon emitted by the organic light emitting layer irradiates the air layer, the photon is reflected and refracted on an interface of an incident medium (the incident medium in Fig.1 is a glass substrate, and the incident in Fig.2 medium is a semitransparent cathode) and the air, and an incidence angle and a refraction angle meet a relational expression: n₁·sinθ₁=n₂·sinθ₂, wherein n₁ represents a refractive index of the incident medium, n₂ represents a refractive index of the air. When the incidence angle is greater than or equal to a critical angle, total reflection occurs, and rays cannot be emitted to the air. In Fig.1 and Fig.2, rays a and b are emitted into the air after being refracted, while rays c and d perform total reflection on the interface and thus cannot escape from the surface of the glass substrate, since the incidence angle thereof is greater than or equal to the critical angle, namely an "escape cone" of a certain angle exists, which reduces a light extraction efficiency of the OLED device.

International patent application WO 2016/096937 A1 discloses a radiation curable composition with hydrophilic nanoparticles for use in barrier stacks for protection of sensitive devices against moisture.

US patent US 8 940 562 B1 discloses producing backplanes for AMLCD and AMOLED. Specifically, each and every component of the backplanes can be printed. Depending on the resolution and screen size of the displays, backplanes can include over a million different components that must be printed that include components of the thin film transistor (TFT) and electrodes to address each of those TFTs.

International patent application WO 2014/178798 A1 discloses an encapsulation barrier stack, capable of encapsulating a moisture and/or oxygen sensitive article and comprising a multilayer film, wherein the multilayer film comprises: - one or more barrier layer(s) having low moisture and/or oxygen permeability, and - one or more sealing layer(s) arranged to be in contact with a surface of the at least one barrier layer, thereby covering defects present in the barrier layer, wherein the one or more sealing layer(s) comprise(s) a plurality of dendrimer encapsulated nanoparticles, the nanoparticles being reactive in that they are capable of interacting with moisture and/or oxygen to retard the permeation of moisture and/or oxygen through the defects present in the barrier layer.

US patent application US 2007/042174 A1 discloses a double-shell blister packaging (1) for medicinal contents comprising one or more cavityies of a similar shape to the medicinal content, said double-shell packaging (1) being the assembly of a first and second mutilayer structures sealed to each other, each multilayer structure comprising a seal layer (3), one or more aluminium layers (4) with a thickness of at least 20 µm, preferably 30 µm, and two or more support layers (2), wherein said two or more support layers (2) have a tensile strength at break in machine and transversal direction of 200 N/mm2 or more, and an elongation at break of 50% or more, preferably 70% or more, measured according to EN ISO 527-3, each of said multilayer structures comprising cavities which, arranged face to face, enclose in use said medicinal content.

International patent application WO 2004/029176 A1 discloses a touchscreen comprising touch side and device side electrodes wherein each electrode comprises in order an insulating substrate, a first electrically conductive layer in contact with said substrate, an exposed electrically conductive layer, wherein said exposed electrically conductive layers are adjacent and separated by dielectric spacers, and wherein at least the first electrically conductive layers or the exposed electrically conductive layers comprise carbon nanotube.

Chinese patent application CN 102 701 143 A1 discloses a lithography process with a micro-nano lens for auxiliary light condensation. The process can realize the preparation of an ordered micro-nano structure. The micro-nano lens covers a substrate and is used as a light condensing mask, and photoresist is exposed by using a light condensing effect of ordered micro-nano hemispheres on the micro-nano lens.

### SUMMARY OF THE INVENTION

In view of the above problem of low light extraction efficiency of the existing OLED device, the present invention provides a method for preparing an uneven particle layer, an organic light emitting diode device and a display device containing the uneven particle layer.

The technical solution for solving the technical problem in the present invention is as follows:
a method for preparing an uneven particle layer including the following steps:
forming a nanoparticle layer comprising nanoparticles on a substrate, wherein the nanoparticles are made of transparent polymer material and have a particle size of 400-700 nm;
fusing the nanoparticles that are in contact with the substrate by heating on a side of the substrate with no nanoparticle layer, whereas the nanoparticles on the surface keep a solid state; and
cooling the substrate,
wherein the transparent polymer material has a glass transition temperature of T₁ and the heating temperature is T₁ to T₁+50 °C.

Preferably, the step of forming a nanoparticle layer on a substrate is to coat a mixed solution of the nanoparticles which includes the nanoparticles, a solvent used for dispersing the nanoparticles and a dispersant, on the substrate.

Preferably, the nanoparticle layer is composed of a single layer of nanoparticles.

Preferably, the transparent polymer material includes polystyrene and/or polymethacrylate.

Preferably, the heating time is 1-20min.

Preferably, the shape of the nanoparticles is a sphere.

Preferably, the thickness of the uneven particle layer is less than 1000 nm.

Preferably, before coating the mixed solution of the nanoparticles, an electrode is arranged on the substrate in advance.

The present invention further provides an OLED device, including a substrate, an anode, an organic light emitting layer and a cathode, wherein the substrate includes an uneven particle layer prepared according to the above method.

The present invention further provides a display device, including the aforementioned OLED device.

According to the method for preparing the uneven particle layer in the present invention, only coating and heating steps need to be added, so the method is simple and industrial production is easy to achieve. A level of the unevenness of the surface of the uneven particle layer prepared by the method is uniform, and the periodicity thereof is good. The substrate including the uneven nanoparticle layer is applied to the OLED device, the performance of the device is stable, and the propagation direction of rays from the organic light emitting layer of the OLED device can be changed to avoid total reflection on an interface so as to emit more light into the air, thereby improving the light extraction efficiency of the OLED device and improving the brightness and the viewing angle of the OLED device. The OLED device prepared by the method in the present invention is suitable for various display devices.

### BRIEF DESCRIPTION OF THE DRAWINGS

Fig.1 is a structural schematic diagram of an existing OLED device;
Fig.2 is a structural schematic diagram of another existing OLED device;
Fig.3 is a schematic diagram of a method for preparing an uneven particle layer according to the present invention;
Fig.4 is a structural schematic diagram of an OLED device according to the third embodiment of the present invention;
Fig.5 is a schematic diagram of light emission of the OLED device according to the third embodiment of the present invention;

### DESCRIPTION OF THE PREFERRED EMBODIMENT

In order that those skilled in the art can better understand the technical solutions of the present invention, a further detailed description of the present invention will be given below in combination with the accompany drawings and specific embodiments.

According to an embodiment of the present invention, a method for preparing an uneven particle layer is provided, including the following steps:
forming a nanoparticle layer on a substrate;
heating the substrate to fuse nanoparticles that are in contact with the substrate, whereas the nanoparticles on the surface keep a solid state; and
cooling the substrate to form a nanoparticle layer with an uneven surface.

As show in Fig.3, the method specifically includes the following steps:
S1, forming a nanoparticle layer on a substrate, which is realized by:
mixing nanoparticles with a solvent used for dispersing the nanoparticles and a dispersant, to form a mixed solution of the nanoparticles; and then, coating the mixed solution of the nanoparticles on the substrate 4.

The nanoparticles can be made of an inorganic material or an organic material. Preferably, the nanoparticles are made of a transparent polymer material. The transparent polymer material includes, but not limited to, polystyrene, polymethylacrylic acid, etc.

As the transparent polymer material is adopted, when the substrate 4 with the uneven particle layer is applied to an OLED device, the light extraction efficiency can be improved.

Preferably, the nanoparticles can be polystyrene and/or polymethacrylate. Preferably, the nanoparticle layer is composed of a single layer of nanoparticles.

The nanoparticles are mixed with the solvent and the dispersant, and the nanoparticles can be uniformly dispersed by the solvent and the dispersant, so as to obtain a nanoparticle layer with a uniform thickness. The obtained nanoparticle layer can reduce total reflection and improve the light extraction efficiency of an OLED device. Particularly, the dispersant is helpful to improve the arrangement of the nanoparticles on the surface of the substrate 4 and prevent the accumulation of the nanoparticles, so it is helpful to form a single layer of nanoparticles.

Those skilled in the art can select a suitable solvent and a suitable dispersant according to the type of the specifically selected nanoparticles. When the nanoparticles are polystyrene, methanol or toluene and the like organic solvents can be adopted; and when the nanoparticles are polymethacrylate, chloroform, acetic acid, ethyl acetate, acetone and the like organic solvents can be adopted. Preferably, a solvent with strong volatility is adopted. Those skilled in the art can select the dispersant adaptive to the nanoparticles according to experience, for example, PVP (polyvinyl pyrrolidone), etc.

Preferably, the shape of the nanoparticles is a sphere.

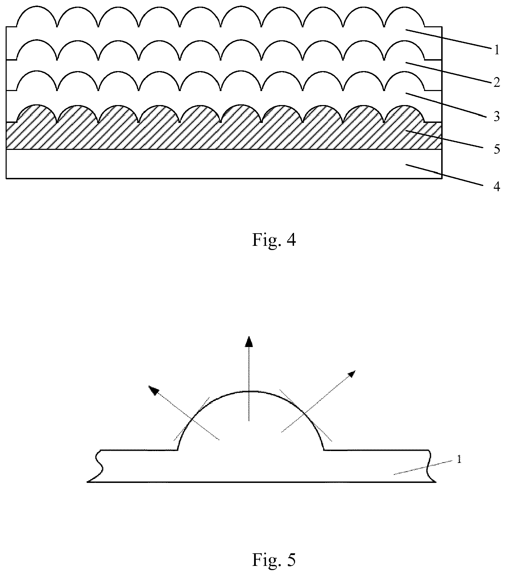

When the shape of the nanoparticles is a sphere, the unevenness of the surface of the uneven particle layer 5 prepared by the method is uniform, and the periodicity thereof is good. When the uneven particle layer is applied to an OLED device, the rays do not perform total reflection on the spherical surfaces, and the emission direction of the rays is the same as the normal direction, as shown in Fig.5.

Preferably, the particle size of the nanoparticles is 400-700 nm.

That is to say, if the particle size of the nanoparticles is too large or too small, it is unbeneficial to controlling the thickness of the formed uneven particle layer 5, and when the particle size of the nanoparticles is 400-700nm, the coating operation and the heating formation operation are easy to carry out.

The mixed solution of the nanoparticles can be coated on the substrate 4 by adopting a conventional coating method. Preferably a spin coating mode is applied by which it can be guaranteed that a film layer with a uniform thickness is formed by the mixed solution on the substrate 4 and a monomolecular layer of polystyrene nanoparticles is formed.

S2, heating the substrate 4 to fuse nanoparticles that are in contact with the substrate, whereas the nanoparticles on the surface keep a solid state;
Preferably, the heating is carried out on a side of the substrate 4 not coated with nanoparticles. That is to say, the back surface of the substrate 4 is heated, by which the nanoparticles on the substrate 4 are heated, so the molecular motion thereof accelerates and a part of nanoparticles are gradually fused, thereby changing the surface morphology of the nanoparticles so as to form an uneven surface.

Preferably, the heating time is 1-20 min, preferably 1-10 min and more preferably 2-5 min. Those skilled in the art can change the specific heating time for different nanoparticle materials according to experience.

Preferably, if the glass transition temperature of the transparent polymer is T₁, the heating temperature is T₁ to T₁+50 °C, preferably T₁ to T₁+30°C, and more preferably T₁ to T₁+15°C. That is, the heating temperature is between the glass transition temperature of the transparent polymer and the glass transition temperature thereof plus 50°C. Upon exceeding the glass transition temperature, polymer macromolecules start to be unfastened and are gradually fused. According to the time-temperature equivalence principle, the heating time necessary for a higher heating temperature is shorter, and on the contrary, if the heating temperature is lower, the necessary heating time is longer. Specifically, if the glass transition temperature of the polystyrene nanoparticles is 80°C, then the heating temperature is not greater than 130°C and is between 80-130°C. The heating time is longer at 80°C, and the heating time is shorter at 130°C.

S3, cooling the substrate 4to form a nanoparticle layer 5 with an uneven surface
Preferably, the thickness of the uneven particle layer 5 is less than 1000nm, so as to guarantee better performance of an OLED device prepared by the method.

Preferably, before coating the mixed solution of the nanoparticles, an anode 3 is arranged on the substrate 4. In such case, the mixed solution of the nanoparticles coated on the substrate 4 is actually coated on the anode 3.

In another specific embodiment of the present invention, an OLED device is provided, including a substrate, an anode, an organic light emitting layer and a cathode, wherein the substrate is prepared according to the above method and includes an uneven particle layer. Apparently, the OLED device in the specific embodiment can be in a form of top light emission and can also in the form of bottom light emission.

Another solution of the present invention provides a display device, including the aforementioned OLED device. The display device can be any product or component having a display function, such as electronic paper, a mobile phone, a tablet computer, a television, a display, a notebook computer, a digital picture frame, a navigator, etc.

### Example 1

As shown in Fig.4, an OLED device A is provided , , including a substrate 4, an anode 3, an organic light emitting layer 2 and a cathode 1, wherein the substrate 4 includes an uneven particle layer prepared according to the above method.

The nanoparticles are polystyrene nanoparticles with a particle size of 600 nm, the solvent is methanol, and the dispersant is polyvinylpyrrolidone (PVP).

The substrate 4 is made of a polyethylene terephthalate (PET) material. The anode 3 is made of aluminum, and the thickness of the anode 3 is 150 nm.

The specific preparation steps include:
adding the polystyrene nanoparticles with a particle size of 600 nm and the dispersant PVP into the solvent methanol, and mixing them uniformly to form a mixed solution;
coating the mixed solution on the PET substrate 4;
heating a surface not coated with nanoparticle of the substrate 4 at 110°C for 2min to fuse the nanoparticles close to the substrate 4, and keep the nanoparticles away from the substrate 4 in a solid state to form a hemisphere;
cooling the substrate 4 to form an uneven particle layer 5 on the substrate;
forming the anode 3 on the substrate 4 after the above steps are completed;
forming the organic light emitting layer 2 on the substrate 4 after the above steps are completed; and
forming the cathode 1 on the substrate 4 after the above steps are completed.

### Comparative example 1

An OLED device B is manufactured by the same method as Example 1, and the difference lies in that no uneven particle layer 5 is formed.

A brightness test is carried out on the OLED device A and the OLED device B. Under the same voltage, the brightness of the OLED device A is 1.2 times as large as the brightness of the OLED device B at a front viewing angle (θ=0°, Φ=0°), and the brightness of the device A is 1.5 times as large as the brightness of the device B at a side viewing angle (θ=45°, Φ=45°).

### Example 2

As shown in Fig.4, an OLED device C is provided, including a substrate 4, an anode 3, an organic light emitting layer 2 and a cathode 1, wherein the substrate 4 includes an uneven particle layer prepared according to the above method.

The nanoparticles are polymethylacrylic acid nanoparticles with a particle size of 600 nm, the solvent is methanol, and the dispersant is PVP.

The substrate 4 is made of a glass material, the anode 3 is made of aluminum, and the thickness of the anode 3 is 150 nm.

The specific preparation steps include:
adding the polymethylacrylic acid nanoparticles with a particle size of 600 nm and the dispersant PVP into the solvent methanol, and mixing them uniformly to form a mixed solution;
coating the mixed solution on the PET substrate 4;
heating a surface not coated with nanoparticle of the substrate 4 at 120°C for 2 min to fuse the nanoparticles close to the substrate 4, and keep the nanoparticles away from the substrate 4 in a solid state to form a hemisphere;
cooling the substrate 4 to form an uneven particle layer 5 on the substrate;
forming the anode 3 on the substrate 4 after the above steps are completed;
forming the organic light emitting layer 2 on the substrate 4 after the above steps are completed; and
forming the cathode 1 on the substrate 4 after the above steps are completed.

### Comparative example 2

An OLED device D is manufactured by the same method as the Example 2, and the difference lies in that no uneven particle layer 5 is formed.

A brightness test is carried out on the OLED device C and the OLED device D. Under the same voltage, the brightness of the OLED device A is 1.3 times as large as the brightness of the OLED device B at a front viewing angle (9=0°, Φ=0°), and the brightness of the device A is 1.6 times as large as the brightness of the device B at a side viewing angle (9=45°, Φ=45°).

## Claims

1. A method for preparing an uneven particle layer, comprising the following steps:
forming a nanoparticle layer (5) comprising nanoparticles on a substrate (4), wherein the nanoparticles are made of transparent polymer material and have a particle size of 400-700 nm;
fusing the nanoparticles that are in contact with the substrate (4) by heating on a side of the substrate (4) with no nanoparticle layer (5), whereas the nanoparticles on the most surface keep a solid state; and
cooling the substrate (4),
wherein the transparent polymer material has a glass transition temperature of T₁ and the heating temperature is T₁ to T₁+50°C.

2. The method for preparing the uneven particle layer according to claim 1, wherein the step of forming a nanoparticle layer (5) on the substrate (4) is to coat a mixed solution of the nanoparticles comprising the nanoparticles, a solvent used for dispersing the nanoparticles and a dispersant on the substrate.

3. The method for preparing the uneven particle layer according to claim 1, wherein the transparent polymer material comprises polystyrene and/or polymethacrylate.

4. The method for preparing the uneven particle layer according to claim 1, wherein the heating time is 1-20min.

5. The method for preparing the uneven particle layer according to claim 1, wherein the nanoparticle has a shape of sphere.

6. The method for preparing the uneven particle layer according to claim 1, wherein the uneven particle layer has a thickness of less than 1000nm.

7. The method for preparing the uneven particle layer according to claim 1, wherein the nanoparticle layer (5) is composed of a single layer of nanoparticles.

8. The method for preparing the uneven particle layer according to claim 2, wherein before coating the mixed solution of the nanoparticles, an electrode is arranged on the substrate.

9. An organic light emitting diode device, comprising a substrate (4), an anode (3), an organic light emitting layer (2) and a cathode (1), wherein the OLED device further comprises an uneven particle layer prepared by the method of any one of claims 1-8.

10. A display device, comprising the OLED device of claim 9.

## Patentansprüche

1. Verfahren zur Herstellung einer unebenen Partikelschicht, die folgenden Schritte umfassend:
Bilden einer Nanopartikelschicht (5) mit Nanopartikeln auf einem Substrat (4), wobei die Nanopartikel aus einem transparenten Polymermaterial hergestellt sind und eine Partikelgröße von 400-700 nm aufweisen;
Verschmelzen der Nanopartikel, die in Kontakt mit dem Substrat (4) sind, durch Erhitzen auf einer Seite des Substrats (4) ohne Nanopartikelschicht (5), während die Nanopartikel auf der meisten Oberfläche einen festen Zustand behalten; und
Kühlen des Substrats (4),
wobei das transparente Polymermaterial eine Glasübergangstemperatur von T₁ hat und die Heiztemperatur T₁ bis T₁+50 °C beträgt.

2. Verfahren zur Herstellung der unebenen Partikelschicht nach Anspruch 1, wobei der Schritt des Bildens einer Nanopartikelschicht (5) auf dem Substrat (4) darauf basiert, eine Mischlösung der Nanopartikel auf dem Substrat aufzutragen, die die Nanopartikel, ein Lösungsmittel, das zum Dispergieren der Nanopartikel verwendet wird, und ein Dispergiermittel enthält.

3. Verfahren zur Herstellung der unebenen Partikelschicht nach Anspruch 1, wobei das transparente Polymermaterial Polystyrol und/oder Polymethacrylat umfasst.

4. Verfahren zur Herstellung der unebenen Partikelschicht nach Anspruch 1, wobei die Heizzeit 1-20 min beträgt.

5. Verfahren zur Herstellung der unebenen Partikelschicht nach Anspruch 1, wobei das Nanopartikel eine Kugelform aufweist.

6. Verfahren zur Herstellung der unebenen Partikelschicht nach Anspruch 1, wobei die unebene Partikelschicht eine Dicke von weniger als 1.000 nm aufweist.

7. Verfahren zur Herstellung der unebenen Partikelschicht nach Anspruch 1, wobei die Nanopartikelschicht (5) aus einer einzigen Schicht von Nanopartikeln gebildet ist.

8. Verfahren zur Herstellung der unebenen Partikelschicht nach Anspruch 2, wobei vor dem Auftragen der Mischlösung der Nanopartikel eine Elektrode auf dem Substrat angeordnet wird.

9. Organische Leuchtdiodenvorrichtung, ein Substrat (4), eine Anode (3), eine organische lichtemittierende Schicht (2) und eine Kathode (1) aufweisend, wobei die OLED-Vorrichtung ferner eine unebene Partikelschicht aufweist, die durch das Verfahren nach einem der Ansprüche 1 bis 8 hergestellt ist.

10. Anzeigevorrichtung, die OLED-Vorrichtung nach Anspruch 9 aufweisend.

## Revendications

1. Procédé de préparation d'une couche de particules irrégulière, comprenant les étapes suivantes consistant à :
former une couche de nanoparticules (5) comprenant des nanoparticules sur un substrat (4),
dans lequel les nanoparticules sont constituées de matériau polymère transparent et ont une taille de particules allant de 400 à 700 nm ;
fusionner les nanoparticules qui sont en contact avec le substrat (4) par chauffage d'un côté du substrat (4) sans couche de nanoparticules (5), tandis que les nanoparticules sur la majorité de la surface conservent un état solide ; et
refroidir le substrat (4),
dans lequel le matériau polymère transparent a une température de transition de verre de T1 et la température de chauffage est T1 à T1 + 50 ° C.

2. Procédé de préparation de la couche de particules irrégulière selon la revendication 1,
dans lequel l'étape consistant à former une couche de nanoparticules (5) sur le substrat (4) consiste à recouvrir le substrat d'une solution mélangée des nanoparticules comprenant les nanoparticules, un solvant utilisé pour disperser les nanoparticules et un dispersant.

3. Procédé de préparation de la couche de particules irrégulière selon la revendication 1,
dans lequel le matériau polymère transparent comprend du polystyrène et / ou du polyméthacrylate.

4. Procédé de préparation de la couche de particules irrégulière selon la revendication 1,
dans lequel le temps de chauffage est de 1 à 20 min.

5. Procédé de préparation de la couche de particules irrégulière selon la revendication 1,
dans lequel la nanoparticule a une forme de sphère.

6. Procédé de préparation de la couche de particules irrégulière selon la revendication 1,
dans lequel la couche de particules irrégulière a une épaisseur inférieure à 1000 nm.

7. Procédé de préparation de la couche de particules irrégulière selon la revendication 1,
dans lequel la couche de nanoparticules (5) est composée d'une seule couche de nanoparticules.

8. Procédé de préparation de la couche de particules irrégulière selon la revendication 2,
dans lequel avant de recouvrir avec la solution mélangée des nanoparticules, une électrode est agencée sur le substrat.

9. Dispositif de diode électroluminescente organique comprenant un substrat (4), une anode (3), une couche électroluminescente organique (2) et une cathode (1), dans laquelle le dispositif OLED comprend en outre une couche de particules irrégulière préparée par le procédé selon l'une quelconque des revendications 1 à 8.

10. Dispositif d'affichage comprenant le dispositif OLED selon la revendication 9.
